# EUROPEAN PATENT APPLICATION

(11) **EP 2 346 196 A1**
(43) Date of publication of application: **20.07.2011**
(21) Application number: 09817259.6
(22) Date of filing: 25.09.2009
(51) Int. Cl.: H04L 1/00

(54) **RECEIVER, RECEIVING DEVICE, AND METHOD FOR TERRESTRIAL MOBILE MULTIMEDIA BROADCASTING**

(30) Priority: 26.09.2008 CN 200810223334
(71) Applicant: Beijing Nufront Mobile Multimedia Tech. Co., Ltd., Beijing 100084 (CN)
(72) Inventor: BAO, Dongshan, Beijing 100084 (CN); SI, Hongwei, Beijing 100084 (CN); LIU, Fei, Beijing 100084 (CN); ZHOU, Yubao, Beijing 100084 (CN)
(74) Representative: Delumeau, François Guy
(86) International application number: PCT/CN2009/074214
(87) International publication number: WO 2010/037345

(57) **Abstract**

A receive for Terrestrial Mobile Multimedia Broadcasting T-MMB, includes a ratio frequency demodulation unit, for carrying out radio frequency demodulation for a received signal; a synchronization unit, for identifying the transmission mode and the synchronous position of the signal from the radio frequency demodulation unit; an OFDM demodulation unit, for extracting a phase reference symbol. Fast Information Channel FIC symbols and dada symbols from the signal which is from the radio frequency demodulation unit according to the transmission mode and the synchronous position, carrying out OFDM demodulation and decoding for the FIC symbols to obtain FIC information, carrying out OFDM demodulation for the data symbols of the corresponding sub-channel according to the sub-channel indication information; and a demodulation and decoding unit, for carrying out differential demodulation for the data symbols after the OFDM demodulation, carrying out time-domain deinterleaving for the data symbols after differential demodulation according to the indication of the FIC information, and carrying out forward error correction decoding for the data symbols after the time-domain deinterleaving. The invention also discloses a receiving device and a receiving method for T-MMB.

## Description

### FIELD OF THE INVENTION

The present invention relates to digital information transmission technology, and more particularly to a receiver, a receiving device, and a receiving method for Terrestrial Mobile Multimedia broadcasting (T-MMB).

### BACKGROUND OF THE INTENTION

Digital multimedia broadcasting is multimedia broadcasting mode used for a handheld terminal, and in digital multimedia broadcasting technology more attention is paid to Digital Video Broadcasting Handheld (DVB-H) technology, Terrestrial Digital Multimedia Broadcasting (T-DMB) technology and T-MMB technology at present.

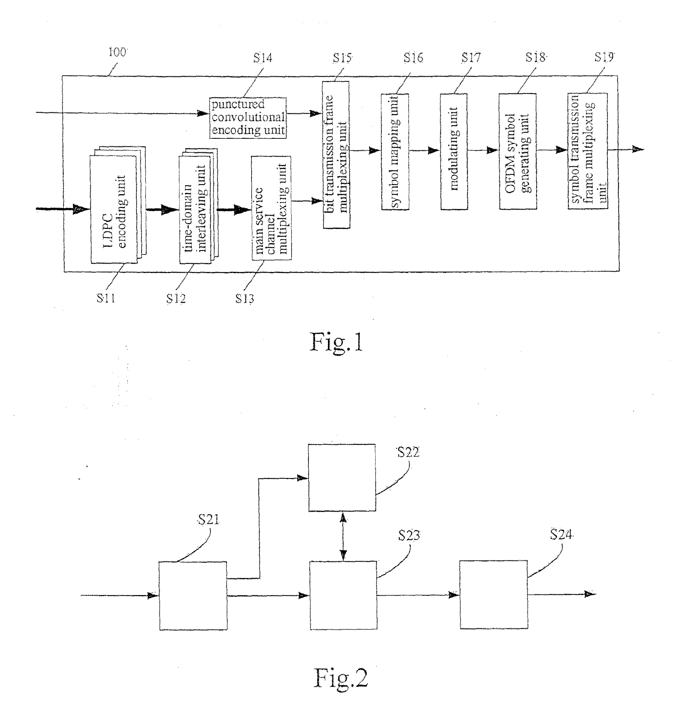

FIG. 1 shows a transmitting device 100 for transmitting T-MMB, which comprises: a plurality of Low Density Parity Check (LDPC) encoding units S11 and time-domain interleaving units S12, a main service channel multiplexing unit S13, a punctured convolutional encoding unit S14, a bit transmission frame multiplexing unit S15, a symbol mapping unit S16, a modulating unit S17, an Orthogonal Frequency Division Multiplexing (OFDM) symbol generating unit S18 and a symbol transmission frame multiplexing unit S19.

In the transmitting device 100, a interleaving in time-domain is performed on the data in a sub-channel in a variable mode and a differential modulation is performed on MSC data in a fixed mode, so that it is required to indicate the interleaving depth to be used. In Fast Information Channel (FIC), the punctured convolutional encoding unit S14 performs a punctured convolutional encoding on a second set of data including the configuration information. In the Main Service Channel (MSC), each route consisting of LDPC encoding unit S11 and time-domain interleaving unit S12 connected in series perform a LDPC encoding and interleaving in time-domain independently on the data in a sub-channel: and the main service, channel multiplexing unit S13 composes the interleaved data in each sub-channel output from each of the time-domain interleaving unit S12 into a Common Interleaved Frame (CIF). Herein, the capacity of a sub-channel is calculated in terms of Capacity Unit (CU), therein the magnitude of a CU is 32 × n bits, and the value of n is related with the symbol mapping mode, i.e., n is related with the mode of differential modulation. For example, when the symbol mapping mode is Social Phase Shrift Keying (8PSK), n = 3; and when the symbol mapping mode is 16-ary Phase Shrift Keying (16PSK), n = 4. After the LDPC encoding unit S11 performs the LDPC encoding on the data in the sub-channel the time-domain interleaving unit S12 perform the interleaving in time-domain between LDPC encoded blocks of the same sub-channel on the encoded data according to the interleaving depth indicated by the configuration information. The main service channel multiplexing unit S13 arranges CUs of the same length continuously and inserts fitting data between CUs of different lengths, so as to compose the data interleaved in time-domain in each sub-channel into CIF. The bit transmission frame multiplexing unit S15 performs a bit transmission frame multiplexing on the CIF obtained by the main service channel multiplexing unit S13 and the convolutional encoded FIC data obtained by the punctured convolutional encoding unit S14, so that the two-path of data are combined into one-path data bit stream. The symbol mapping unit S16 performs a symbol mapping on CIF, namely MSC data with a fixed mapping mode (QPSK, 8PSK or 16PSK), and on FIC data with QPSK. Then, the modulating unit S17 performs corresponding differential modulations on CIF and FIC data to obtain differential-modulation symbol sequences. The OFDM symbol generating unit S18 perform an OFDM modulation on the differential-modulation symbols sequences along with phase reference symbols and empty symbols to generate respective OFDM symbols. The symbol transmission frame multiplexing unit S19 multiplexers continuous OFDM symbols generated by the OFDM symbol generating unit S18 into signal unit transmission frames.

To date, a specific receiver for T-MMB has not been proposed yet.

### SUMMARY OF THE INVENTION

In view of the above circumstance, the technical problem to be solved by the present invention is to provide a specific receiver for T-MMB.

In some embodiments, the receiver for T-MMB comprises: a radio frequency demodulation unit for carrying out radio frequency demodulation for a received signal; a synchronization unit for identifying the transmission mode and the synchronous position of the signal from the radio frequency demodulation unit; an OFDM demodulation unit for extracting a phase reference symbol. Fast information Channel FIC symbols and data symbols from the signal which is from the radio frequency demodulation unit according to the transmission mode and the synchronous position, carrying out a OFDM demodulation and decoding for the FIC symbols to obtain FIC information, and carrying out an OFDM demodulation for the data symbols of the corresponding sub-channel according two the sub-channel indication information; and a demodulation and decoding unit for carrying out a differential demodulation for the data symbols after the OFDM demodulation, carrying out a time-domain deinterleaving for the data symbols after differential demodulation according to the indication of the FIC information, and carrying out a forward error correction decoding for the data symbols after the time-domain deinterleaving.

Another- technical problem to be salved by the present invention is to provide a specific receiving device for-T-MMB.

In some embodiments, the receiving device for T-MMB comprises: a first unit for carrying out a differential demodulation for the data symbols after OFDM demodulation: a second unit for carrying out a time-domain deinterleaving for the data symbols after the differential demodulation according to the interleaving depth indicated by FIC information; and a third unit for carrying out a FEC decoding for the data symbols after the time-domain deinterleaving.

Another technical problem to be solved by the present invention is to provide a specific receiving method for T-MMB.

In some embodiments, the receiving method for T-MMB comprises the steps of: carrying out a differential demodulation for the data symbols after OFDM demodulation; carrying out a time-domain deinterleaving, for the data symbols after the differential demodulation according to the interleaving depth indicated by FIC information; and carrying out a FEC decoding for the data symbols after the time-domain deinterleaving.

### BRIEF OF THE DRAWINGS

FIG. 1 is a schematic diagram showing a transmitting device for T-MMB;
FIG. 2 is a schematic diagram showing an embodiment of a receiver for T-MMB;
FIG. 3 is a schematic diagram showing an embodiment of a device for T-MMB receiving;
FIG. 4 is a schematic diagram showing another embodiment of a device for T-MMB receiving;
FIG. 5 is a schematic diagram showing another embodiment of a device for T-MMB receiving;
FIG 6 is a flow chart showing an embodiment of a method for T-MMB receiving;

### DETAILED DESCRIPTION OF THE EMBODIMENTS

To make the objects, technical solution and advantages of this invention more apparent, hereinafter, embodiments are taken with reference to the accompanying drawings to further describe this present invention in detail.

T-MMB , which merges latest technologies into a whole and takes frequency point resource, complexity of receiver, frequency spectrum utilization ratio, system performance and so on into account, is a digital multimedia broadcasting mode based on multimedia business expansion of digital audio broadcasting (DAB) system, realizing a complete compatibility with DAB, low-cost design, goof availability for frequency point, supporting moving reception, being achieved with single frequency net, high frequency spectrum efficiency, multiple businesses, high quality service and so on. T-MMB has the characteristics as follows.
(1) T-MMB has the technical superiority of receiving signal reliably in the high-speed mobile environment, and can functionary expand singly transmitter audio information, to many kinds of carrier, such as data, texts, graphics and videos.
(2) The efficiency of a frequency band is high.
(3) Low Density Parity Check (LDPC) and high efficient and low complex differential modulation scheme are adapted.
(4) Compares with other system such as DVB-H, it has the advantage of low complexity, low power consumption, good availability for frequency point, good compatibility, etc.

FIG. 2 shows the structure of a receiver for T-MMB. The receiver comprises: a radio frequency demodulation unit S21, a synchronization unit S22, an OFDM demodulation unit S23 and a demodulation and decoding unit S24.

The radio frequency demodulation unit S21 carries out a radio frequency demodulation for the radio frequency signal received from outsize, and outputs the radio frequency demodulated signal to the synchronization unit S22 and the OFDM demodulation unit S23.

Herein, the radio frequency demodulation unit S21 comprises a tuner, an analog-to-digital (A/D) conversion nodule, a down-conversion module, a low pass filter and a down-sampling module.

The synchronization unit S22 receives the signal output from the radio frequency demodulation unit S21, identifies corresponding transmission mode of the received signal, outputs a mode identification result to the OFDM demodulation unit S23, determines the synchronous position of the received signal according to the mode recognition result and Outputs the asynchronous position to the OFDM demodulation unit S23.

Herein, the synchronous position includes but is not limited to a frame edge, a symbol edge and a timing location;

The OFDM demodulation unit S23 extracts a phase reference symbol, FIC symbols and data symbols from the signal which is from the radio frequency demodulation unit S21 according to the mode identification result output from the synchronization unit S22; carries out a OFDM demodulation and decoding for the FIC symbols according to the phase reference symbol to obtain FIC information, and uses the FIC information to carry out a OFDM demodulation for the data symbols of sub-channel selected by a user according to sub-channel indication information.

Herein, the signal of each frame in the signal received by the receiver consists of an empty symbol, a phase reference symbol, and FIC symbols and data symbols determined by different mode. The empty symbols is used for the frame synchronization of the receiver. The phase reference symbol is used for providing a phase reference for the differential phase modulation and demodulation of the subsequent data: and the information of the phase reference symbol is known by the received, so it can also be used as carrier synchronization.

The sub-channel indication information, may be obtained from the channel election indication input by a user. When a user selects a program of a channel, the sub-channel transmitting the program of the selected channel can be determined accordingly.

The FIC information comprises the location and length information of each sub-channel and the level information, of the interleaving depth of each sub-channel, and may also comprise information related to the modulation mode of each sub-channel, the encoding mode of each sub-channel and so on according to needs.

The demodulation and decoding unit S24 carries out a differential demodulation for the data symbols after the OFDM demodulation, carries out a time-domain deinterleaving for the data symbols after differential demodulation according to the indication of the FIC information, and carries out a FEC decoding for the data symbols after the time-domain deinterleaving.

The demodulation and decoding unit S24 may carry out the time-domain deinterleaving for the data symbols according to the corresponding interleaving depth of its sub-channel indicated by the FIC information. Herein, there are many modes for the FIC information to indicate the interleaving depth of each sub-channel, an optional mode is that the interleaving depth information of each sub-channel is carried in the FIC information directly, and another optional mode is that the information about the level of the interleaving depth of each sub-channel is carried in the FIC information, and the interleaving depth of each sub-channel is determined by the level of the interleaving depth of each sub-channel and the data rate of each corresponding sub-channel. In this embodiment, the information about the level of the interleaving depth of each sub-channel is carried in the FIC information, so it is required to determine the interleaving depth of the sub-channel, to which the data symbols belong, according to the level of the interleaving depth and the data rate of the sub-channel, to which the data symbols belong, indicated by the FIC information.

When the demodulation and decoding unit S24 carries out the differential demodulation for the data symbols, the demodulation should be carried out according to the mode with which a transmitter modulated the data symbols. If the transmitter carries out a modulation in a fixed mode, the demodulation and decoding unit S24 also carries out the demodulation in a fixed mode accordingly; and if the transmitter carries out the modulation according to an indication, the demodulation and decoding unit S24 also carries out the demodulation according to an indication accordingly. For example, if the transmitter carries out the modulation in a fixed 8DPSK mode, the demodulation and decoding unit S24 also carries out the differential demodulation for the data symbols in an 8DPSK mode fixedly; and if the transmitter carries out the modulation for the data symbols according, to the mode indicated by the FIC, the demodulation and decoding unit S24 should also carry out the differential demodulation according to the modulation mode indicated by the FIC accordingly.

In the same way, when the demodulation and decoding unit S24 carries out the FEC decoding for the data symbols, the decoding should also be carried out according to the encoding mode of the transmitter accordingly. If the transmitter carries out an encoding in a fixed mode, the demodulation and decoding unit S24 also carries out the decoding in a fixed mode accordingly; and if the transmitter carries out the encoding according to an indication, the demodulation and decoding unit S24 also carries out the decoding according to an indication accordingly. For example, if the transmitter uses a fixed LDPC encoding, the demodulation and decoding unit S24 also carries out a LDPC decoding fixedly; and if the transmitter has a variety of encoding modes to be selected from, the demodulation and decoding unit S24 should also carry out the decoding according to the encoding mode indicated by the FIC accordingly.

Furthermore, if the transmitter carries out a frequency-domain interleaving for the data symbols, the demodulation and decoding unit S24 carries out a frequency-domain deinterleaving for the data symbols accordingly. When the frequency-domain deinterleaving is required to carry out, the demodulation and decoding unit S24 may carry out the frequency-domain deinterleaving for the data symbols before the differential demodulation or between the differential demodulation and the time-domain deinterleaving.

It can be seen that using the receiver shown in FIG. 2 can realize the receiving and demodulation for the T-MMB signal, so as to realize the integral transmitting of T-MMB.

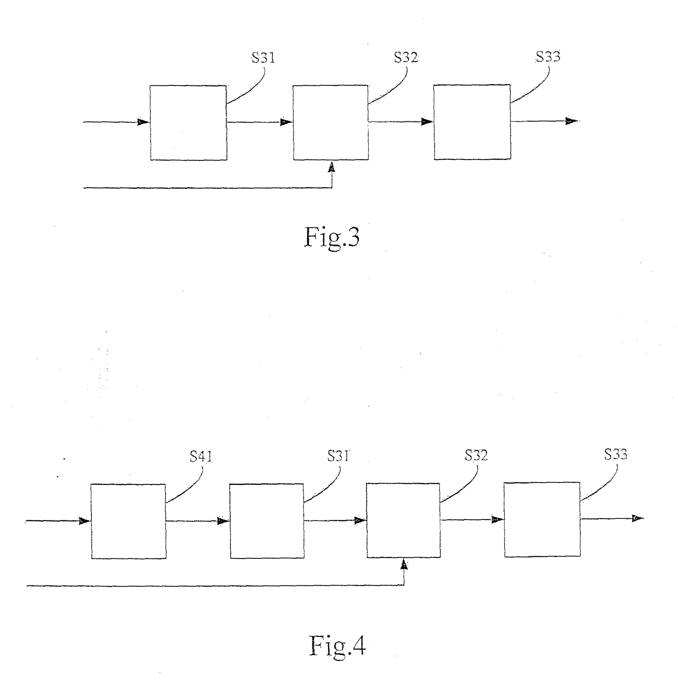

FIG. 3 shows a structure of a receiving device for T-MMB. The receiving device shown in FIG. 3 comprises a first unit S31, a second unit S32 and a third unit S33.

The first unit S3 carries out a differential demodulation for the data symbols after the OFDM demodulation, the second unit S32 carries out a time-domain deinterleaving for the data symbols after the differential demodulation according to the interleaving depth indicated by FIC information, and the third unit S33 carries out a FEC decoding for the data symbol after the time-domain deinterleaving.

Wherein, the interleaving depth can be determined by the level of the interleaving depth and the data rate or the sub-channel to which the data symbols belong indicated by the FIC information.

When the first unit S31 carries out the differential demodulation for the data symbols, the demodulation should be carried out according to the mode with which the transmitter modulates the data symbols accordingly. If the transmitter carries out a modulation in a fixed mode, the first unit S31 also carries out the demodulation in a fixed mode accordingly; and if the transmitter carries out the modulation according to an indication, the first unit S31 also carries out the demodulation according to an indication accordingly. For example, if the transmitter carries out the modulation in a fixed 8DPSK mode, the first unit S31 also carries out the differential demodulation for the data symbols in an 8DPSK mode fixedly: and if the transmitter carries out the modulation for the data symbols according to the mode indicated by the FIC, the first unit S31 should also carry out the differential demodulation according to the modulation mode indicated by the FIC accordingly.

In the same way, when the third unit S33 carries out the FEC decoding for the data symbols, the decoding should also be carried out according to the encoding mode of the transmitter accordingly. If` the transmitter carries out an encoding in a fixed mode, the third unit S33 also carries out the decoding in a fixed mode accordingly; and if the transmitter carries out the encoding according to an indication, the third unit S33 also carries out the decoding according to an indication accordingly. For example, if the transmitter uses a fixed LDPC encoding, the third unit S33 also carries out LDPC decoding fixedly; and if the transmitter has a variety of encoding modes to be selected from, the third unit S33 should also carry out the decoding accordingly according two the encoding mode indicated by the FIC.

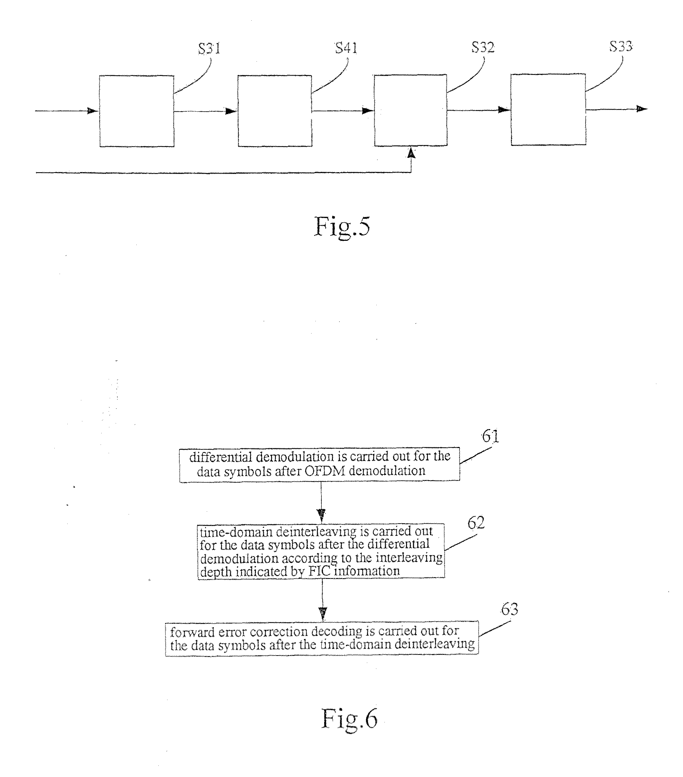

Furthermore, is the transmitter carries out a frequency-domain interleaving for the data symbols, the receiving device should carry out a frequency-domain deinterleaving for the data symbols accordingly. When the receiving device, is required to carry out frequency-domain deinterleaving, a forth unit S41 which carries out the frequency-domain deinterleaving for the data symbol may be connected in series in frost of the first unit S31 as shown in FIG. 4; or a fourth unit S41 which carries out the frequency-domain deinterleaving for the data symbols may be connected in series between the first unit S31 any the second unit S32 as shown in FIG. 5.

FIG. 6 shows a flow chart of a receiving method for T-MMB.

In step 61, a differential demodulation is carried out for the data symbols after OFDM demodulation.

In step 62, a time-domain deinterleaving is carried out for the data symbols after the differential demodulation according to the interleaving depth indicated by FIG information, wherein the interleaving depth can be determined by the level of the interleaving depth and the data rate of the sub-channel of the data symbols to which the data symbols belong indicated by the FIC information.

In step 63, a forward error correction decoding is carries out for the data symbols after the time-domain deinterleaving.

Whin the differential demodulation for the data symbols is carried out, the demodulation should be carried out accordingly according to the mode with which the transmitter modulates the data symbols, If the transmitter carries out a modulation in a fixed mode, the demodulation is carried out in a fixed mode accordingly; and if the transmitter carries out the modulation according to an indication, the demodulation is carried out according to an indication accordingly. For example, if the transmitter carries out the modulation in a fixed 8DPSK mode, the differential demodulation for the data symbols is carried out in an 8DPSK mode fixedly-, and if the transmitter carries out the modulation for the data symbols according to the mode indicated by the FIC, the differential demodulation should also be carried out according to the modulation mode indicated by the FIC accordingly.

In the same way, when FEC decoding for the data symbols is carried out, the decoding should also be carried out accordingly according to the encoding mode of the transmitter. If the transmitter carries out an encoding in a fixed mode, the decoding is carried out in a fixed mode accordingly; and if the transmitter carries out the encoding according to an indication, the decoding is carried out according to an indication accordingly. For example, if the transmitted uses a fixed LDPC encoding, an LDPC decoding is carried out fixedly; and if the transmitter has a variety of encoding modes to be selected from, the decoding should also be carried out accordingly according to the encoding mode indicated by the FIC.

Furthermore, if the transmitter carries out a frequency-domain interleaving for the data symbols, the frequency-domain deinterleaving for the data symbol should be carried out accordingly. When the frequency-domain deinterleaving is required to carry out, the frequency-domain deinterleaving for the data symbols may be carried out before the differential demodulation or between the differential demodulation and the time-domain deinterleaving.

The present invention further provides an integrated circuit for implementing the device or method described in any of the above embodiments. The present invention further providers a computer readable medium for storing programs which are useful for implementing the method described in any of the above embodiments.

It will be appreciated for the person skilled in the art that various exemplary steps of method and units of device described herein with reference to the disclosed embodiments can be implemented by the electronic hardware, software, or the combination thereof. To clearly show the interchangeability between hardware and software, a general description has been made to the various exemplary steps and units with respect to their functional forms. Whether this functionality is implemented by hardware or software depends on the specific application and the design constraints realized by the whole system. The person skilled in the art may implement the described functionality in a variety of ways in connection with each specific application, but it should not be construed that this implementation departs from the scope of the present invention.

The exemplary units described in the embodiments disclosed herein can be implemented or fulfilled by means of a general purpose processor, a digital signal processor (DSP), an application specific integrated circuit (ASIC), a field programmable gate array (FPGA) or other programmable logic devices, a discrete gate or transistor logic, a discrete hardware assembly, or any combination thereon. The general purpose processor may be a microprocessor, but in another case the processor may be any conventional processor, controller, microcontroller, or state machine. The processor may also be implemented as a combination of competing devices, for example, the combination of DSP and microprocessor, a plurality of microprocessors, one or more microprocessors incorporating the DSP core, or any other structures of this kind.

The steps of method described in the embodiments described hereinabove may be directly implemented by hardware, a software module executed by a processor, or the combination thereof. The software module can reside in a RAM memory, a flash memory, a ROM memory, an EPROM memory, an EEPROM memory, a register, a hard disk, a removable disk, a CD-ROM, or any other kinds of storage media known in the art. A typical storage medium is coupled with the processor so that the processor is capable of reading information from the storage medium and writing information two the storage medium. In an alternative example, the storage medium is an integral part of the processor. The processor and the storage tedium may reside in an ASIC. The ASIC may reside in a user station. In an alternative example, the processor and the storage medium may be a separate component in the user station.

According two the disclosed embodiments, the person skilled in the art is enabled to implement or carry out the present invention. As for the person skilled in the art, various modification two these embodiments are apparent, and the general principles defined herein can also be applied two other embodiments without departing from the scope and gist of the present invention. The embodiment described above are only the preferred embodiments of the present invention, and do not limit the present invention in any way. All oaf the modifications, equivalent, improvements or the like within the spirit and principle of the present invention should fall within the protection scope of the present invention.

## Claims

1. A receives for terrestrial mobile multimedia broadcasting, **characterized in that** the receiver comprises:
a radio frequency demodulation unit for carrying out a radio frequency demodulation for a received signal;
a synchronization unit for identifying the transmission mode and the synchronous position of the signal from the radio frequency demodulation unit;
an OFDM demodulation unit for extracting a phase reference symbol, Fast Information Channel FIC symbols and data symbols from the signal which is from the radio frequency demodulation unit according to the transmission mode and the synchronous position, carrying out a OFDM demodulation and decoding for the FIC symbols to obtain FIC information, and carrying out a OFDM demodulation for the data symbols of the corresponding sub-channel according to the sub-channel indication information; and
a demodulation and decoding unit for carrying out a differential demodulation for the data symbols after the OFDM demodulation, carrying out a time-domain deinterleaving for the data symbols after differential demodulation according to the indication of the FIC information, and carrying out a forward error correction decoding for the data symbols after the time-domain deinterleaving.

2. The receive of claim 1, **characterized in that** the demodulation and decoding unit carries out the time-domain deinterleaving for the data symbols after the differential demodulation according to the interleaving depth of the sub-channel indicated by the FIC information.

3. The receiver of claim 2, **characterized in that** the interleaving depth of the sub-channel is determined by the level of the interleaving depth and the data rate of the sub-channel indicated by the FIC information.

4. The receiver of claim 2, **characterized in that** the demodulation and decoding unit carries out the differential demodulation for the data symbols with DQPSK, 8DUSK or 16DPSK mode.

5. The receive or claim 2, **characterized in that** the demodulation and decoding unit carries out Low Density Parity Check LDPC decoding for the data symbols after the time-domain deinterleaving.

6. The receive of claim 2, **characterized in that** the demodulation and decoding unit, carries out the differential demodulation according to the modulation mode indicated by the FIC.

7. The receive of claim 2, **characterized in that** the demodulation and decoding unit carries out forward the error correction decoding according to the encoding mode indicated by the FIC.

8. The receive of any one of claims 2-7, **characterized in that** the demodulation and decoding unit is further used for carrying out a frequency-domain deinterleaving for the data symbols after the OFDM demodulation.

9. The receiver of claim 8, **characterized in that** the demodulation and decoding unit carries out the frequency-domain deinterleaving before the differential demodulation.

10. A receiving device for terrestrial mobile multimedia broadcasting, **characterized in that** the receiving device comprises:
a first unit for carrying out a differential demodulation for the data symbols after Orthogonal Frequency Division Multiplexing OFDM demodulation:
a second unit for carrying out a time-domain deinterleaving for the data symbols after the differential demodulation according to the interleaving depth indicated by Fast Information Channel FIC information; and
a third unit for carrying out a forward error correction decoding for the data symbols after the time-domain deinterleaving.

11. The receiving device of claim 10, **characterized in that** the interleaving depth is determined by the level of the interleaving depth and the data rate of the sub-channel to which the data symbols belong indicated by the FIC information.

12. The receiving device of claim 10, **characterized in that** the first unit carries out the differential demodulation for the data symbols with 8DPSK mode.

13. The receiving device of claim 10. **characterized in that** the third unit carries out Low Density Parity Check LDPC decoding for the data symbols after the time-domain deinterleaving.

14. The receiving device of claim 10, **characterized in that** the first unit carries out the differential demodulation according to the modulation mode indicated by the FIC.

15. The receiving device of claim 10, **characterized in that** the third unit carries out the forward error correction decoding according to the encoding mode indicated by the FIC.

16. The receiving device of any one of claim 10-15. **characterized in that** a fourth unit, which carries out a frequency-domain deinterleaving for the data symbols is further connected in series between the first unit and the second unit.

17. A receiving method for terrestrial mobile multimedia broadcasting, **characterized in that** the receiving method comprised the steps off:
carrying out a differential demodulation for the data symbols after Orthogonal Frequency Division Multiplexing OFDM demodulation;
carrying out a time-domain deinterleaving for the data symbols after the differential demodulation according to the interleaving depth indicated by Fast Information Channel FIC information: and
carrying out a forward error correction decoding for the data symbols after the time-domain deinterleaving.

18. The receiving method of claim 17, **characterized in that** the interleaving depth is determined by the level of the interleaving depth and the data rate of the sub-channel to which the data symbols belong indicated by the FIC information.

19. The receiving method of claim 17, **characterized in that** the differential demodulation for the data symbols is carried out with DQPSK, 8DPSK or 16DPSK mode.

20. The receiving method of claim 17, **characterized in that** Low Density Parity Check LDPC decoding is carried out for the data symbols after the time-domain deinterleaving.

21. The receiving method of claim 17, **characterized in that** the differential demodulation is carried out according to the modulation mode indicated by the FIC.

22. The receiving method of claim 17, **characterized in that** the forward error correction decoding is carried out with the encoding mode indicated by the FIC.
